# EUROPÄISCHE PATENTSCHRIFT

(11) **EP 2 668 835 B1**
(45) Veröffentlichungstag und Bekanntmachung des Hinweises auf die Patenterteilung: **22.10.2014**
(21) Anmeldenummer: 12709271.6
(22) Anmeldetag: 24.01.2012
(51) Int. Cl.: H05K 1/18

(54) **VERFAHREN ZUR INTEGRATION EINES ELEKTRONISCHEN BAUTEILS IN EINE LEITERPLATTE ODER EIN LEITERPLATTEN-ZWISCHENPRODUKT**
METHOD FOR INTEGRATING AN ELECTRONIC COMPONENT INTO A PRINTED CIRCUIT BOARD OR A PRINTED CIRCUIT BOARD INTERMEDIATE PRODUCT
PROCÉDÉ D'INTÉGRATION D'UN COMPOSANT ÉLECTRONIQUE DANS UNE CARTE À CIRCUIT IMPRIMÉ OU UN PRODUIT INTERMÉDIAIRE DE CARTE À CIRCUIT IMPRIMÉ

(30) Priorität: 26.01.2011 AT 412011
(43) Veröffentlichungstag der Anmeldung: 04.12.2013
(73) Patentinhaber: AT & S Austria Technologie & Systemtechnik Aktiengesellschaft, 8700 Leoben-Hinterberg (AT)
(72) Erfinder: WEIDINGER, Gerald, 8700 Leoben (AT); ZLUC, Andreas, A-8700 Leoben (AT); STAHR, Johannes, A-8605 St. Lorenzen (AT)
(74) Vertreter: Matschnig, Franz
(86) Internationale Anmeldenummer: PCT/AT2012/000011
(87) Internationale Veröffentlichungsnummer: WO 2012/100274

(56) Entgegenhaltungen:
- US-A1- 2006 291 173
- US-A1- 2008 196 930
- US-A1- 2009 230 541
- US-A1- 2010 044 845
- US-A1- 2010 214 750

## Beschreibung

Die vorliegende Erfindung bezieht sich auf ein Verfahren zur Integration wenigstens eines elektronischen Bauteils in eine Leiterplatte oder ein Leiterplatten-Zwischenprodukt.

Im Zusammenhang mit wachsenden Produktfunktionalitäten von mit elektronischen Bauteilen versehenen Geräten und einer zunehmenden Miniaturisierung derartiger elektronischer Bauteile sowie einer zunehmenden Anzahl elektronischer Bauteile, mit welchen Leiterplatten zu bestücken sind, werden zunehmend leistungsfähige feld- bzw. arrayförmig aufgebaute Bauteile bzw. Packages mit mehreren elektronischen Komponenten eingesetzt, die eine Vielzahl von Kontakten bzw. Anschlüssen bei zunehmend verringertem Abstand dieser Kontakte aufweisen. Zur Festlegung bzw. Kontaktierung derartiger Bauteile wird zunehmend der Einsatz von stark entflochtenen Leiterplatten erforderlich, wobei davon auszugehen ist, dass bei einer gleichzeitigen Verringerung der Produktgröße sowie der einzusetzenden Bauteile und Leiterplatten sowohl hinsichtlich der Dicke als auch der Fläche derartiger Elemente zu erwarten ist, dass eine Bestückung bzw. Anordnung derartiger elektronischer Bauteile über die erforderliche Vielzahl von Kontaktstellen an Leiterplatten problematisch wird bzw. an Grenzen der möglichen Auflösung derartiger Kontaktstellen gelangt.

Zur Lösung derartiger Probleme wurde zwischenzeitlich vorgeschlagen, elektronische Bauteile wenigstens teilweise in eine Leiterplatte zu integrieren, wobei beispielsweise auf die WO 03/065778, die WO 03/065779 oder die WO 2004/077902 verwiesen wird. Bei diesen bekannten Verfahren bzw. Ausführungsformen von in einer Leiterplatte integrierten, elektronischen Bauteilen bzw. Komponenten ist jedoch nachteilig, dass für die Aufnahme derartiger elektronischer Bauteile bzw. Komponenten jeweils Ausnehmungen bzw. Löcher in einem Grundelement einer Leiterplatte vorzusehen sind, wobei darüber hinaus vor Anordnung eines Bauteils in einem derartigen Loch Leiterbahnen ausgebildet werden. Für eine Kontaktierung der Bauteile werden Lötprozesse und Bondtechniken eingesetzt, wobei üblicherweise Kontaktstellen zwischen Materialien unterschiedlichen Typs zwischen Elementen der Leiterbahnen als auch den Kontakt- bzw. Anschlussstellen der elektronischen Bauteile resultieren. Vor allem bei einem Einsatz derartiger Systeme in Umgebungen mit großem Temperaturunterschied bzw. Temperaturwechselbereichen ergeben sich durch den Einsatz unterschiedlicher Materialien im Bereich der Kontakt- bzw. Anschlussstellen unter Berücksichtigung der unterschiedlichen thermischen Ausdehnungskoeffizienten mechanisch bzw. thermisch induzierte Spannungen, welche zum Riss wenigstens einer Kontakt- bzw. Anschlussstelle und somit zum Versagen des Bauteils führen können. Darüber hinaus ist davon auszugehen, dass zusätzlich erforderliche Bohrungen, insbesondere Laserbohrungen, zur Herstellung von Kontaktflächen die Komponenten belasten. Weiters ist nachteilig, dass eine Kontaktierung der in den herzustellenden Ausnehmungen bzw. Vertiefungen eingebetteten Bauteile an Leiterbahnen und Kontaktflächen durch Lötpasten oder Bonddrähte erschwert wird bzw. insbesondere bei einem Einsatz mit schwankenden Temperaturbelastungen nicht zuverlässig erzielbar ist. Ergänzend ist nachteilig, dass gegebenenfalls vorzusehende, hohe Drücke und Temperaturen während des Leiterplatten-Herstellungsprozesses die eingebetteten und kontaktierten Komponenten belasten. Weiters ist eine Wärmeableitung von gegebenenfalls stärker belasteten, elektronischen Bauteilen problematisch.

Aus der US 2008/0196930 A1 und der US 2010/0214750 A1 sind Verfahren zur Herstellung einer Leiterplatte bzw. zur Einbettung eines elektronischen Bauteils in eine Leiterplatte bekannt geworden, wobei in einer leitenden Schicht Freistellungen entsprechend von Kontakten eines zu integrierenden bzw. festzulegenden Bauteils vorgesehen sind, so dass ein hoher Aufwand betreffend die Ausbildung und Positionierung derartiger Freistellungen unter Berücksichtigung der kleinen Abmessungen derartiger Kontakte erforderlich ist.

Abgewandelte Ausführungsformen zum Einbetten von Bauteilen in eine Leiterplatte sind der US 2009/0230541 A1, der US 2006/0291173 A1 oder der US 2010/0044845 A1 zu entnehmen, wobei beispielsweise auf eine Vereinfachung einer Kontaktierung abgezielt wird.

Die vorliegende Erfindung ist in Anspruch 1 definiert, sie zielt darauf ab, die oben genannten Probleme bei einer Integration wenigstens eines elektronischen Bauteils in eine Leiterplatte zu minimieren oder zu beheben und zielt insbesondere darauf ab, ein Verfahren der eingangs genannten Art zur Verfügung zu stellen, bei welchem bei einfachen Verfahrensschritten eine einfache und zuverlässige Anordnung eines derartigen elektronischen Bauteils in einer Leiterplatte bzw. in einem Leiterplatten-Zwischenprodukt bei insbesondere einfacher

Registrierung und verringerter Dicke der herzustellenden Leiterplatte bzw. des herzustellenden Leiterplatten-Zwischenprodukts erzielbar ist.

Zur Lösung dieser Aufgaben umfasst ein Verfahren der eingangs genannten Art im wesentlichen die folgenden Schritte:
- Bereitstellen einer Schicht zur wenigstens temporären Abstützung des elektronischen Bauteils,
- Festlegen des elektronischen Bauteils auf der Schicht, wobei Kontakte des elektronischen Bauteils oder eine auf einer Oberfläche des elektronischen Bauteils angeordnete leitende Schicht zu der abstützenden Schicht orientiert wird bzw. werden,
- Anordnen einer leitenden Schicht auf der abstützenden Schicht mit wenigstens einer Freistellung entsprechend den Abmessungen des festzulegenden elektronischen Bauteils
- wenigstens teilweises Ummanteln bzw. Abdecken des auf der abstützenden Schicht festgelegten Bauteils und wenigstens von Teilbereichen der an den Bauteil angrenzenden, auf der abstützenden Schicht angeordneten, leitenden Schicht mit einem isolierenden Material, beispielsweise einer Prepreg-Folie und/oder einem Harz,
- Freilegen der Kontakte oder der leitenden Schicht des elektronischen Bauteils sowie wenigstens von Teilbereichen der an den Bauteil angrenzenden, auf der abstützenden Schicht angeordneten, leitenden Schicht nach einem bzw. durch ein Entfernen der abstützenden Schicht, und
- wenigstens teilweises Kontaktieren der Kontakte oder der leitenden Schicht des elektronischen Bauteils mit der an den Bauteil angrenzenden leitenden Schicht.

Durch ein Anordnen einer leitenden Schicht auf der abstützenden Schicht mit wenigstens einer Freistellung entsprechend den Abmessungen des festzulegenden elektronischen Bauteils und/oder der zu der abstützenden Schicht gerichteten Kontakte des Bauteils gelingt es, eine derartige leitende Schicht auf gleicher Höhe wie die Kontakte oder die leitende Schicht des einzubettenden elektronischen Bauteils anzuordnen, wodurch in weiterer Folge eine einfache Kontaktierung dieser leitenden Schicht mit dem integrierten elektronischen Bauteil ermöglicht wird. Durch Anordnung dieser leitenden Schicht auf gleicher Höhe wie eine nachfolgend freizulegende Oberfläche des zu integrierenden elektronischen Bauteils gelingt darüber hinaus eine Verringerung der gesamten Höhe der herzustellenden Leiterplatte bzw. des zu herstellenden Leiterplatten-Zwischenprodukts. Darüber hinaus lässt sich durch ein derartiges Anordnen der leitenden Schicht im wesentlichen auf gleicher Höhe wie eine freizulegende Oberfläche des zu integrierenden Bauteils eine Kontaktierung des Bauteils mit den daran anschließenden Bereichen der leitenden Schicht vereinfachen, so dass insgesamt eine Leiterplatte bzw. ein Leiterplatten-Zwischenprodukt mit vereinfachter bzw. verbesserter Anordnung des zu integrierenden elektronischen Bauteils als auch einer vereinfachten Kontaktierung desselben erhältlich ist. Weiters lässt sich durch die Freistellung bzw. Ausnehmung der leitenden Schicht die Registrierung bzw. Ausrichtung des elektronischen Bauteils bei seiner Anordnung bzw. Festlegung vereinfachen bzw. erleichtern.

Für eine einfache und zuverlässige Festlegung des zu integrierenden elektronischen Bauteils ist gemäß einer bevorzugten Ausführungsform des erfindungsgemäßen Verfahrens vorgesehen, dass der elektronische Bauteil auf der abstützenden Schicht unter Vermittlung eines Klebers, einer klebenden Folie, einer adhäsiven Beschichtung des Bauteils oder dgl. festgelegt wird. Insbesondere entsprechend den weiteren Bearbeitungsschritten können somit unterschiedliche Mittel zur Festlegung des elektronischen Bauteils auf der abstützenden Schicht vorgesehen werden, wobei diese nicht nur mit entsprechend geringerer Dicke zur Verfügung gestellt werden können, sondern auch ein einfaches und zuverlässiges Freilegen der leitenden Schicht und der Kontakte des zu integrierenden Bauteils nach einem Ummanteln desselben ermöglicht wird.

Insbesondere im Hinblick auf eine Verringerung der gesamten Dicke der herzustellenden Leiterplatte oder des Leiterplatten-Zwischenprodukts wird gemäß einer weiters bevorzugten Ausführungsform vorgeschlagen, dass die Klebeschicht oder -folie oder Beschichtung mit einer Dicke von maximal 15 µm, insbesondere etwa 0,1 bis 10 µm ausgebildet wird. Erfindungsgemäß lässt sich somit mit einer vergleichsweise geringeren Dicke einer Klebeschicht oder -folie das Auslangen finden, wobei trotz einer derartigen geringen Dicke der Klebeschicht oder-folie ein zuverlässiges Anhaften bzw. Festlegen des elektronischen Bauteils auf der abstützenden Schicht ermöglicht wird.

Für ein besonders einfaches und zuverlässiges Aufbauen der Klebeschicht wird darüber hinaus vorgeschlagen, dass eine Klebeschicht durch Tintenstrahl-, Flex-, Tiefen- oder Offsetdruck aufgebracht wird, wie dies einer weiters bevorzugten Ausführungsform des erfindungsgemäßen Verfahrens entspricht.

Zur einfachen Bereitstellung bzw. Anordnung der leitenden Schicht in an den aufzunehmenden bzw. abzustützenden Bauteil angrenzenden Teilbereichen wird gemäß einer weiters bevorzugten Ausführungsform vorgeschlagen, dass die an den Bauteil angrenzende leitende Schicht von einer metallischen Folie, insbesondere Cu-Folie gebildet wird. Eine derartige metallische Folie, insbesondere Cu-Folie lässt sich mit entsprechend gewünschter Dicke bereitstellen und lässt sich mit einfachen und bei der Herstellung einer Leiterplatte bekannten Verfahrensschritten anordnen und mit weiteren Schichten bzw. Elementen einer derartigen Leiterplatte oder eines Leiterplatten-Zwischenprodukts verbinden.

Insbesondere in Abhängigkeit von dem Einsatzzweck des zu integrierenden elektronischen Bauteils und/oder der Orientierung der Kontakte oder einer leitenden Schicht des Bauteils zu der abstützenden Schicht wird gemäß einer weiters bevorzugten Ausführungsform vorgeschlagen, dass die metallische Folie, insbesondere Cu-Folie, insbesondere für eine leitfähige Struktur mit einer Dicke von maximal 15 µm, insbesondere etwa 0,1 bis 10 µm ausgebildet wird. Derart wird bei entsprechend geringer Dicke für die metallische Folie, insbesondere Cu-Folie eine einfache und zuverlässige Kontaktierung mit den Kontakten des zu integrierenden elektronischen Bauteils mit einer insbesondere strukturierten, dünnen, leitfähigen Schicht zur Verfügung gestellt.

Sollte insbesondere bei integrierenden Bauteilen hoher Leistung, welche während ihres Einsatzes bzw. Betriebs vergleichsweise große Wärmemengen entwickeln, welche entsprechend abgeleitet werden müssten, eine gute Wärmeableitung in Seiten- bzw. Randbereichen des zu integrierenden elektronischen Bauteils erforderlich sein, so wird gemäß einer abgewandelten und bevorzugten Ausführungsform des erfindungsgemäßen Verfahrens vorgeschlagen, dass die metallische Folie, insbesondere Cu-Folie, insbesondere für eine Wärmeableitung mit einer Dicke von maximal 500 µm, insbesondere etwa 35 bis 400 µm ausgebildet wird. Durch eine derartige, vergleichsweise große Dicke kann ein zu integrierender elektronischer Bauteil im wesentlichen über seinen gesamten Umfang von einer derartigen metallischen Folie entsprechend guter Wärmeleitfähigkeit umgeben werden, so dass eine Verteilung der von dem zu integrierenden elektronischen Bauteil erzeugten Wärme über größere Flächen bzw. Bereiche der Leiterplatte bzw. des Leiterplatten-Zwischenprodukts erzielbar ist.

Wie bereits oben erwähnt, gelingt in einfacher und zuverlässiger Weise eine Kontaktierung des zu integrierenden elektronischen Bauteils mit der im wesentlichen auf der Höhe bzw. dem Niveau der Kontakte des zu integrierenden elektronischen Bauteils angeordneten zusätzlichen leitenden Schicht, wobei in diesem Zusammenhang gemäß einer weiters bevorzugten Ausführungsform vorgeschlagen wird, dass die an den Bauteil angrenzende leitende Schicht von einer strukturierten Schicht gebildet wird.

Für eine besonders einfache und zuverlässige Kontaktierung der an den einzubettenden elektronischen Bauteil angrenzenden leitenden bzw. einer leitfähigen Schicht wird gemäß einer weiters bevorzugten Ausführungsform vorgeschlagen, dass bei zu der abstützenden Schicht gerichteten Kontakten des elektronischen Bauteils nach einer Entfernung der abstützenden Schicht die Kontakte mit der strukturierten leitenden Schicht kontaktiert bzw. verbunden werden.

Wie oben ebenfalls bereits angedeutet, ist für eine gute Wärmeableitung üblicherweise eine an den Bauteil angrenzende leitende Schicht vergleichsweise großer Dicke vorgesehen, wobei für eine Kontaktierung der leitenden Schicht mit dem insbesondere im Betrieb große Wärmemengen erzeugenden elektronischen Bauteil mit der daran angrenzenden leitenden Schicht vorgeschlagen wird, dass nach der Freilegung der leitenden Schicht des elektronischen Bauteils eine im wesentlichen vollflächige Kontaktierung mit der daran angrenzenden leitenden Schicht vorgenommen wird, wie dies einer weiters bevorzugten Ausführungsform des erfindungsgemäßen Verfahrens entspricht.

Zur Erzielung der gewünschten Wärmeableitung wird in diesem Zusammenhang bevorzugt vorgeschlagen, dass die vollflächige Kontaktierung von einer Schicht aus einem leitenden Material, insbesondere wärmeleitenden Material gebildet wird.

Insbesondere bei Herstellung eines Leiterplatten-Zwischenprodukts, bei welchem in einfacher und zuverlässiger Weise nach einem Freilegen des zu integrierenden elektronischen Bauteils eine Kontaktierung mit entsprechenden weiteren Schichten erfolgt, wird zur Fertigstellung einer Leiterplatte vorgeschlagen, dass nach der Freilegung der leitenden Schicht oder der Kontakte des elektronischen Bauteils und der Kontaktierung mit der daran angrenzenden leitenden Schicht weitere Schichten und/oder Strukturierungen der Leiterplatte ausgebildet bzw. vorgesehen werden.

Entsprechend dem Aufbau im Bereich des zu integrierenden elektronischen Bauteils und insbesondere zur Einbettung desselben und/oder damit verbundener Elemente in der herzustellenden Leiterplatte wird gemäß einer weiteren bevorzugten Ausführungsform des erfindungsgemäßen Verfahrens vorgeschlagen, dass die wenigstens eine weitere Schicht der Leiterplatte mit einer Ausnehmung bzw. Vertiefung im Bereich des integrierten elektronischen Bauteils versehen wird.

Zur Lösung der eingangs genannten Aufgaben besteht darüber hinaus eine Leiterplatte oder ein Leiterplatten-Zwischenprodukt der eingangs genannten Art im wesentlichen aus einem mit einem isolierenden Material, beispielsweise einer Prepreg-Folie und/oder einem Harz wenigstens teilweise ummantelten oder damit abgedeckten elektronischen Bauteil und einer auf Höhe von Kontakten des elektronischen Bauteils oder einer leitenden Schicht einer Oberfläche des elektronischen Bauteils angeordneten, an den Bauteil angrenzenden, leitenden Schicht, wobei die an den Bauteil angrenzende leitende Schicht wenigstens eine Freistellung entsprechend den Abmessungen des festzulegenden elektronischen Bauteils und/oder der damit zu koppelnden Kontakte des Bauteils aufweist und wobei die Kontakte des elektronischen Entsprechend dem Aufbau im Bereich des zu integrierenden elektronischen Bauteils und insbesondere zur Einbettung desselben und/oder damit verbundener Elemente in der herzustellenden Leiterplatte wird gemäß einer weiteren bevorzugten Ausführungsform des erfindungsgemäßen Verfahrens vorgeschlagen, dass die wenigstens eine weitere Schicht der Leiterplatte mit einer Ausnehmung bzw. Vertiefung im Bereich des integrierten elektronischen Bauteils versehen wird.

Weiters wird eine Leiterplatte oder ein Leiterplatten-Zwischenprodukt offenbart im wesentlichen bestehend aus einem mit einem isolierenden Material, beispielsweise einer Prepreg-Folie und/oder einem Harz wenigstens teilweise ummantelten oder damit abgedeckten elektronischen Bauteil und einer auf Höhe von Kontakten des elektronischen Bauteils oder einer leitenden Schicht einer Oberfläche des elektronischen Bauteils angeordneten, an den Bauteil angrenzenden, leitenden Schicht, wobei die an den Bauteil angrenzende leitende Schicht wenigstens eine Freistellung entsprechend den Abmessungen des festzulegenden elektronischen Bauteils aufweist, wobei die Kontakte des elektronischen Bauteils oder die auf einer Oberfläche des elektronischen Bauteils angeordnete leitende Schicht mit der an den Bauteil angrenzenden, leitenden Schicht gekoppelt bzw. koppelbar ist bzw. sind, wobei die an den Bauteil angrenzende leitende Schicht von einer metallischen Folie, insbesondere Cu-Folie gebildet ist, und wobei der auf der abstützenden Schicht festgelegte Bauteil und wenigstens Teilbereiche der an den Bauteil angrenzenden, auf der abstützenden Schicht angeordneten, leitenden Schicht mit einem isolierenden Material beispielsweise einer Prepreg-Folie und/oder einem Harz wenigstens teilweise ummantelt bzw. abgedeckt sind. Wie bereits oben erwähnt, gelingt somit die einfache und zuverlässige Herstellung einer derartigen Leiterplatte oder eines Leiterplatten-Zwischenprodukts, wobei insbesondere durch die an den Bauteil angrenzende Schicht mit einer Freistellung entsprechend den Abmessungen des festzulegenden elektronischen Bauteils eine einfache und zuverlässige Registrierung bzw. Anordnung des zu integrierenden elektronischen Bauteils als auch eine Verringerung bzw. Minimierung der gesamten Höhe der herzustellenden Leiterplatte oder des herzustellenden Leiterplatten-Zwischenprodukts bei entsprechend einfacher Kontaktierung der freigelegten Oberfläche des zu integrierenden elektronischen Bauteils möglich werden. Für eine einfache und zuverlässige Kontaktierung mit den Kontakten des zu integrierenden elektronischen Bauteils wird darüber hinaus vorgeschlagen, dass die an den Bauteil angrenzende leitende Schicht von einer metallischen Folie, insbesondere Cu-Folie gebildet ist.

Insbesondere in Abhängigkeit von dem Einsatzzweck des zu integrierenden elektronischen Bauteils und/oder der Orientierung der Kontakte des zu integrierenden elektronischen Bauteils oder der leitenden Schicht desselben zu der abstützenden Schicht wird gemäß einer weiters bevorzugten Ausführungsform vorgeschlagen, dass die metallische Folie, insbesondere Cu-Folie, insbesondere für eine leitfähige Struktur eine Dicke von maximal 15 µm, insbesondere etwa 0,1 bis 10 µm, aufweist. Derart lässt sich eine leitende bzw. leitfähige Struktur geringer Dicke zur Verfügung stellen, welche ebenfalls zu einer weiteren Reduktion bzw. Minimierung der gesamten Dicke der herzustellenden Leiterplatte bzw. des Leiterplatten-Zwischenprodukts beiträgt.

Während mit entsprechend dünnen Folien eine strukturierte leitfähige Schicht für eine Kontaktierung mit den Kontakten des zu integrierenden Bauteils zur Verfügung gestellt werden kann, ist während des Betriebs bzw. Einsatzes von gegebenenfalls große Wärmemengen erzeugenden elektronischen Bauteilen eine Verteilung der entstehenden Wärme über größere Flächen bzw. Bereiche erforderlich bzw. zielführend, wobei in diesem Zusammenhang vorgeschlagen wird, dass die metallische Folie, insbesondere Cu-Folie, insbesondere für eine Wärmeableitung eine Dicke von maximal 500 µm, insbesondere etwa 35 bis 400 µm, aufweist, wie dies einer weiters bevorzugten Ausführungsform der erfindungsgemäßen Leiterplatte oder des erfindungsgemäßen Leiterplatten-Zwischenprodukts entspricht.

Für eine zuverlässige Kopplung mit zu der abstützenden Schicht gerichteten Kontakten des zu integrierenden elektronischen Bauteils wird gemäß einer weiters bevorzugten Ausführungsform vorgeschlagen, dass für eine Kopplung bzw. Kontaktierung mit Kontakten des elektronischen Bauteils die an den Bauteil angrenzende leitende Schicht von einer strukturierten leitenden Schicht gebildet ist.

Demgegenüber wird für eine einfache und zuverlässige Wärmeableitung von einem gegebenenfalls große Wärmemengen während eines Einsatzes erzeugenden elektronischen Bauteil gemäß einer weiteren abgewandelten und bevorzugten Ausführungsform vorgeschlagen, dass für eine Kopplung bzw. Kontaktierung mit der leitenden Schicht des elektronischen Bauteils eine im wesentlichen vollflächige Kontaktierung mit der daran angrenzenden leitenden Schicht vorgesehen ist.

Für die Unterstützung einer zuverlässigen Wärmeableitung wird darüber hinaus bevorzugt vorgeschlagen, dass die vollflächige Kontaktierung von einer Schicht aus einem leitenden Material, insbesondere wärmeleitenden Material gebildet ist.

Die Erfindung wird nachfolgend anhand von in der beiliegenden Zeichnung schematisch dargestellten Ausführungsbeispielen näher erläutert. In dieser zeigen:
Fig. 1 schematische Verfahrensschritte eines erfindungsgemäßen Verfahrens zur Integration wenigstens eines elektronischen Bauteils in eine erfindungsgemäße Leiterplatte oder ein erfindungsgemäßes Leiterplatten-Zwischenprodukt;

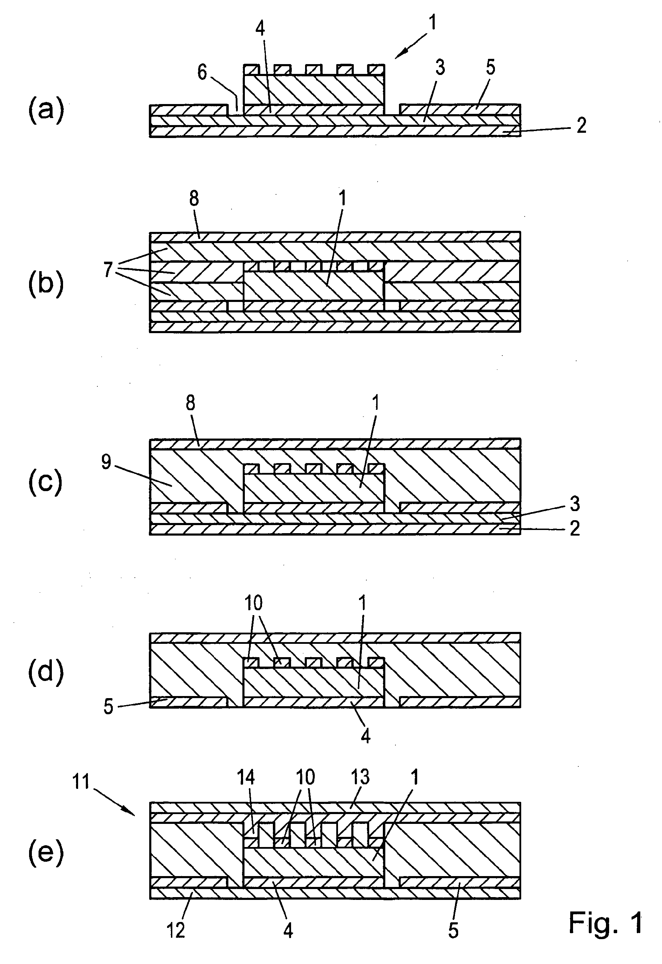

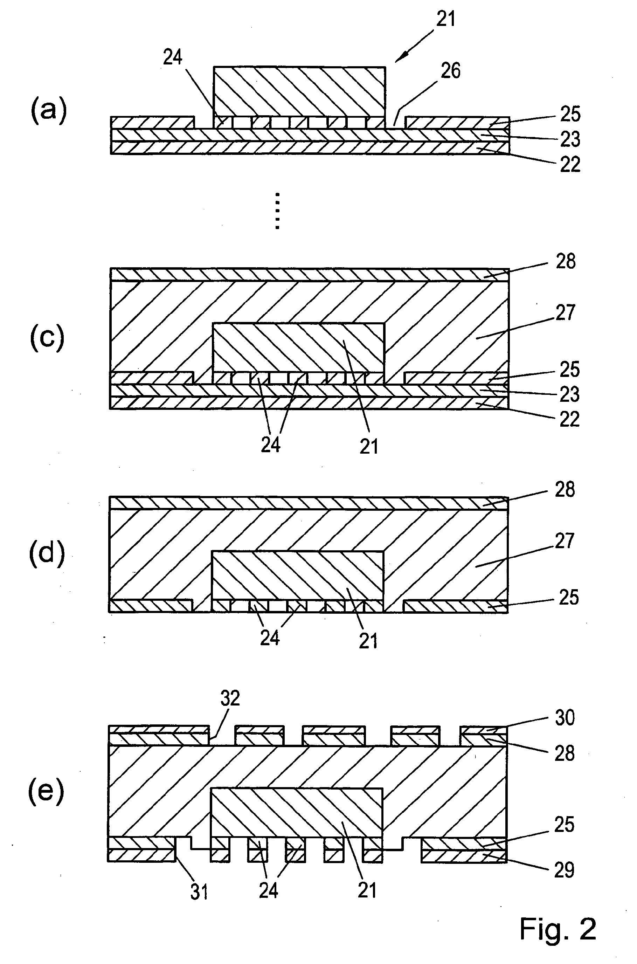

Fig. 2 in einer zu Fig. 1 ähnlichen Darstellung einzelne Verfahrensschritte eines abgewandelten erfindungsgemäßen Verfahrens zur Integration eines elektronischen Bauteils in einer erfindungsgemäßen Leiterplatte bzw. eines erfindungsgemäßen Leiterplatten-Zwischenprodukts, wobei im Gegensatz zu der Darstellung gemäß Fig. 1, bei welcher der zu integrierende elektronische Bauteil mit einer leitenden Schicht zu einer abstützenden Schicht gerichtet ist, bei der Ausführungsform gemäß Fig. 2 der zu integrierende elektronische Bauteil mit zu der abstützenden Schicht gerichteten Kontakten vorgesehen ist;
Fig. 3 eine Darstellung einer weiteren abgewandelten Ausführungsform einer Leiterplatte bzw. eines erfindungsgemäßen Leiterplatten-Zwischenprodukts, wobei insbesondere für eine Wärmeableitung eine eine vergleichsweise große Dicke aufweisende leitende Schicht neben dem zu integrierenden elektronischen Bauteil auf der abstützenden Schicht vorgesehen wird;
Fig. 4 lediglich zwei Verfahrensschritte eines zu der Darstellung gemäß Fig. 2 ähnlichen Verfahrens, wobei wiederum Kontakte eines zu integrierenden elektronischen Bauteils zu der abstützenden Schicht gerichtet sind; und
Fig. 5a und 5b eine Darstellung einer weiteren abgewandelten Ausführungsform eines Verfahrens zur Herstellung einer Leiterplatte oder eines Leiterplatten-Zwischenprodukts, wobei die einzelnen Schichten bzw. Lagen vor einer Verbindung miteinander angedeutet sind.

Zu den beiliegenden Figuren wird allgemein angemerkt, dass die relativen Dicken einzelner Schichten bzw. Lagen sowie die Abmessung derartiger Schichten und Lagen Verbindung miteinander angedeutet sind.

Zu den beiliegenden Figuren wird allgemein angemerkt, dass die relativen Dicken einzelner Schichten bzw. Lagen sowie die Abmessung derartiger Schichten und Lagen insbesondere im Vergleich zu dem zu integrierenden elektronischen Bauteil nicht maßstabsgerecht sind, sondern teilweise zur Verdeutlichung übermäßig große Dicken bzw. Abmessungen aufweisen. Darüber hinaus ist allgemein lediglich eine geringe Anzahl von Kontakten eines zu integrierenden elektronischen Bauteils im Gegensatz zu den üblicherweise eine vergleichweise große Anzahl von derartigen Kontakten aufweisenden Bauteilen dargestellt.

In Fig. 1 erfolgt in einem Verfahrensschritt (a) eine Anordndung bzw. Festlegung eines allgemein mit 1 bezeichneten, in eine herzustellende Leiterplatte bzw. ein herzustellendes Leiterplatten-Zwischenprodukt zu integrierenden Bauteils, wobei die Abstützung bzw. Festlegung des elektronischen Bauteils 1 auf einer abstützenden Schicht 2 erfolgt und zur Festlegung auf der abstützenden Schicht 2 eine Kleberschicht 3 vorgesehen ist.

Bei der in Fig. 1 dargestellten Ausführungsform ist der elektronische Bauteil 1 mit einer leitenden bzw. leitfähigen Schicht 4 zu der abstützenden Schicht 2 bzw. der Kleberschicht 3 gerichtet. Darüber hinaus ist gemäß dem Verfahrensschritt (a) ersichtlich, dass ebenfalls auf der abstützenden Schicht 2 eine leitende Schicht, insbesondere eine metallische Folie bzw. Cu-Folie 5 festgelegt wird, welche entsprechend der Abmessung des anzuordnenden bzw. zu integrierenden elektronischen Bauteils 1 mit einer Ausnehmung bzw. Freistellung ausgebildet ist.

Ebenso wie die nicht maßstabsgetreuen Schichtdicken ist auch der seitliche Abstand der Freistellung bzw. Ausnehmung 6 der Schicht 5 gegenüber den Abmessungen des aufzunehmenden bzw. einzubettenden elektronischen Bauteils 1 übertrieben groß dargestellt.

Die Festlegung sowohl des elektronischen Bauteils 1 über die leitende Schicht 4 als auch der daran anschließenden leitenden Schicht bzw. metallischen Folie 5 erfolgt beispielsweise über einen Kleber, welcher eine entsprechend geringe Dicke von beispielsweise weniger als 15 µm, insbesondere weniger als 5 µm aufweist. Eine derartige Klebeschicht kann beispielsweise durch ein Tintenstrahl-, Flex-, Tiefen- oder Offsetdruckverfahren aufgebracht werden.

Nach einer Anordnung bzw. Festlegung sowohl des elektronischen Bauteils 1 als auch der leitenden Schicht bzw. Folie 5 auf der abstützenden Schicht 2 erfolgt gemäß Schritt (b) eine Anordnung einer Mehrzahl von schematisch angedeuteten Schichten 7 aus einem nicht leitenden Material, beispielsweise einer Mehrzahl von Prepreg-Folien, wobei zusätzlich eine weitere leitende Schicht 8 ebenfalls angedeutet ist.

Nach einer derartigen Anordnung einer Mehrzahl von den elektronischen Bauteil 1 umgebenden bzw. überlagernden Schichten 7 bzw. 8 erfolgt gemäß dem Schritt (c) ein Laminieren und vollständiges Ummanteln des elektronischen und einzubettenden Bauteils 1, wobei in dem Laminierschritt (c) eine Verbindung der einzelnen Schichten bzw. Lagen 7 zu einer gemeinsamen Schicht bzw. Lage 9 aus isolierendem Material erfolgt.

Nach einer derartigen Ummantelung des einzubettenden elektronischen Bauteils 1 gemäß dem Schritt (c) erfolgt im Schritt (d) ein Entfernen sowohl der abstützenden Schicht 2 als auch der Klebeschicht 3, so dass nicht nur die leitende Schicht 5 sondern auch die leitende Schicht 4 des integrierten elektronischen Bauteils 1 freigelegt wird.

Hiebei ist insbesondere ersichtlich, dass die von den Kontakten 10 des elektronischen Bauteils abgewandte leitende Schicht 4 sich im wesentlichen auf derselben Höhe bzw. selben Ebene wie die leitende Schicht 5 befindet, so dass im Verfahrensschritt (d) eine Oberfläche des zu integrierenden elektronischen Bauteils 1 vollkommen freigelegt wird.

Für eine weitere Ausbildung einer schematisch mit 11 bezeichneten Leiterplatte bzw. eines Leiterplatten-Zwischenprodukts 11 erfolgt nach einem Freilegen sowohl der leitenden Schicht 4 des integrierten elektronischen Bauteils 1 als auch der leitenden Schicht bzw. metallischen Folie 5 ein Aufbau von weiteren leitenden Schichten 12 und 13, wobei im Verfahrensschritt (e) darüber hinaus eine Kontaktierung der Kontakte 10 des eingebetteten elektronischen Bauteils 1 über Kontaktierungen, beispielsweise mit leitendem Material gefüllte Bohrungen 14 angedeutet ist.

Aus der Darstellung gemäß Fig. 1 ist darüber hinaus ersichtlich, dass die leitende Schicht 4 des integrierten elektronischen Bauteils 1 beispielsweise für eine gute Wärmeableitung bzw. Wärmeabfuhr im wesentlichen vollflächig mit der zusätzlichen leitenden Schicht 12 und für eine Verteilung der Wärme über größere Teilbereiche auch über eine vollflächige Verbindung mit den daran anschließenden und auf gleicher Höhe befindlichen Teilbereichen der leitenden Schicht bzw. metallischen Folie 5 verbunden ist.

In Fig. 2 ist eine abgewandelte Ausführungsform eines Verfahrens zum Einbetten eines elektronischen Bauteils dargestellt, wobei in einem wiederum mit (a) bezeichneten ersten Verfahrensschritt ein einzubettender elektronischer Bauteil 21 auf einer abstützenden Schicht 22 unter Vermittlung einer Kleberschicht 23 festgelegt wird.

Im Gegensatz zu der Ausführungsform gemäß Fig. 1 erfolgt eine Festlegung des zu integrierenden elektronischen Bauteils 21 auf der abstützenden Schicht 22 bzw. der Klebeschicht 23 mit zu der abstützenden Schicht 22 gerichteten Kontakten 24.

Ähnlich wie bei der Ausführungsform gemäß Fig. 1 ist auf der abstützenden Schicht 22 bzw. der Klebeschicht 23 wiederum eine leitende Schicht bzw. metallische Folie 25 vorgesehen, welche eine Freistellung bzw. Ausnehmung 26 entsprechend den Außenabmessungen des zu integrierenden elektronischen Bauteils 21 aufweist.

Ähnlich dem Verfahrensschritt (c) von Fig. 1 ist in Fig. 2 ebenfalls mit (c) ein Verfahrensschritt bezeichnet, gemäß welchem nach einem nicht näher dargestellten Anordnen einer Mehrzahl von Schichten aus isolierendem Material beispielsweise durch einen Lamenationsvorgang eine vollständige Einbettung des integrierten elektronischen Bauteils 21 in einer Ummantelung 27 aus isolierendem Material vorgesehen wird, wobei ebenso wie bei der Ausführungsform gemäß Fig. 1 eine leitende Schicht 28 angedeutet ist.

Nach einem derartigen Einbetten des elektronischen Bauteils 21 entsprechend dem Schritt (c) der Fig. 2 erfolgt ähnlich wie bei der vorangehenden Ausführungsform gemäß dem Schritt (d) wiederum ein Freilegen sowohl der Kontakte 24 des integrierten elektronischen Bauteils 21 als auch der angrenzenden leitenden Schicht bzw. metallischen Folie 25. Wiederum befinden sich die Kontakte 24 als auch die leitende und insbesondere strukturierte Schicht 25 im wesentlichen auf gleicher Höhe bzw. gleichem Niveau, so dass ähnlich wie bei der vorangehenden Ausführungsform wiederum eine Freilegung einer Oberfläche des integrierten elektronischen Bauteils, welche in diesem Fall die Kontakte 24 aufweist, sowie der leitenden Schicht bzw. metallischen Folie 25 möglich wird.

In einem wiederum mit (e) bezeichneten Schritt erfolgt ein Aufbau weiterer leitender Schichten 29 und 30 als auch eine Strukturierung derselben, wie dies durch Durchbrechungen bzw. Bohrungen 31 und 32 sowie Kontaktierungen mit den Kontakten 24 des integrierten elektronischen Bauteils 21 angedeutet ist.

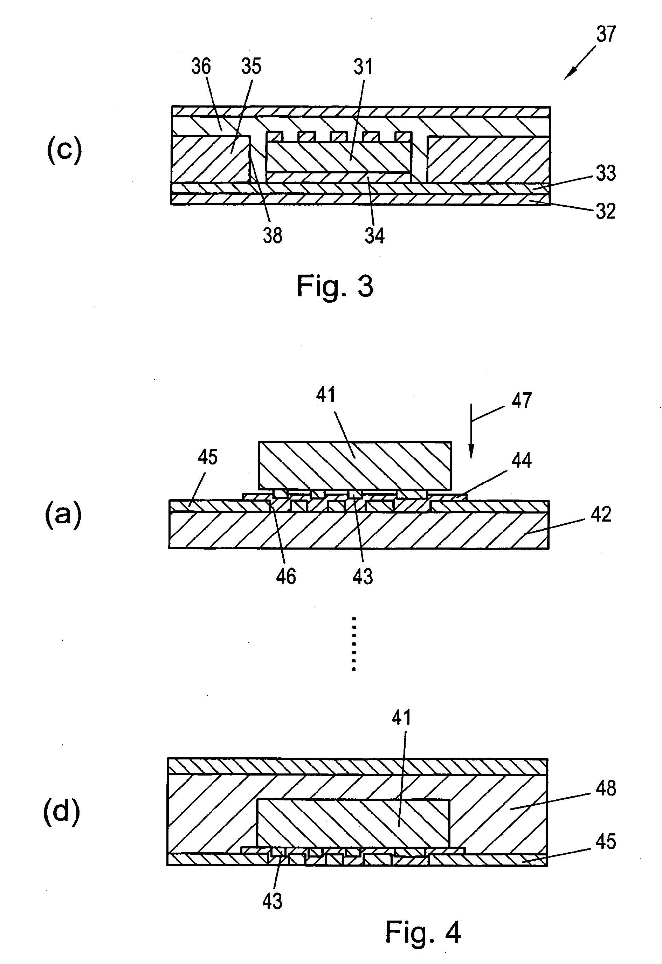

In Fig. 3 ist eine abgewandelte Ausführungsform ähnlich dem Verfahrensschritt (c) von Fig. 1 dargestellt, wobei ersichtlich ist, dass im Gegensatz zu der eine vergleichweise geringe Dicke aufweisenden Schicht bzw. Folie 5 bei der Ausführungsform gemäß Fig. 1 eine an den mit 31 bezeichneten integrierten elektronischen Bauteil angrenzende bzw. anschließende leitende Schicht bzw. metallische Folie 35 mit einer Freistellung 38 eine vergleichweise große Dicke aufweist, welche bei der dargestellten Ausführungsform im wesentlichen der gesamten Höhe des integrierten elektronischen Bauteils 31 entspricht, dessen Höhe beispielsweise einige 100 µm beträgt.

Nach der in Fig. 3 dargestellten Ummantelung des elektronischen Bauteils 31 durch eine mit 36 bezeichnete Schicht aus isolierendem Material erfolgt ähnlich wie bei der Ausführungsform gemäß Fig. 1 wiederum ein Freiliegen sowohl der leitenden Schicht 34 des integrierten elektronischen Bauteils 31 als auch der eine große Dicke aufweisenden, daran angrenzenden Schicht 35, wobei durch eine Anordnung einer zusätzlichen leitenden Schicht, wie dies in Fig. 1 angedeutet ist, eine gute Verteilung von Wärme über große Teilbereiche der Leiterplatte bzw. des Leiterplatten-Zwischenprodukts 37 erfolgen kann.

Bei der Darstellung gemäß Fig. 4 erfolgt ähnlich wie bei der Ausführungsform gemäß Fig. 2 eine Anordnung bzw. Festlegung eines zu integrierenden elektronischen Bauteils 41 mit zu einer abstützenden Schicht 42 gerichteten Kontakten 43, wobei für eine Festlegung eine Klebeschicht 44 angedeutet ist.

Eine darüber hinaus an der abstützenden Schicht 42 vorgesehene leitende Schicht bzw. metallische Folie 45 ist mit einer Mehrzahl von Ausnehmungen bzw. Freistellungen 46 entsprechend den Kontakten 43 des zu integrierenden elektronischen Bauteils 41 versehen, so dass bei einer Anordnung bzw. Festlegung des elektronischen Bauteils 41, wie dies durch den Pfeil 47 angedeutet ist, die Kontakte 42 in die Ausnehmungen bzw. Freistellungen 46 der leitenden Schicht 45 eintreten.

Darüber hinaus ist in Fig. 4 unter Weglassung einiger Zwischenschritte entsprechend den vorangehenden Fig. 1 und 2 ersichtlich, dass nach einem Einbetten des zu integrierenden elektronischen Bauteils 41 in einer Schicht 48 aus isolierendem Material und einem Entfernen der abstützenden Schicht 42 sowohl die Kontakte 43 des Bauteils 41 als auch die daran anschließende leitende Schicht bzw. metallische Folie 45 freigelegt werden. Somit kann ähnlich wie bei der Ausführungsform gemäß Fig. 2 durch nachfolgendes Aufbringen bzw. Anordnen weiterer leitender Schichten und Strukturierung derselben eine einfache und zuverlässige Kontaktierung der Kontakte 43 des integrierten elektronischen Bauteils 41 vorgenommen werden. Wiederum befindet sich die an den elektronischen Bauteil 41 angrenzende leitende Schicht bzw. metallische Folie 45 auf derselben Höhe wie die Kontakte 43 des integrierten elektronischen Bauteils 41, welche nach einem Entfernen der abstützenden Schicht 42 freigelegt werden.

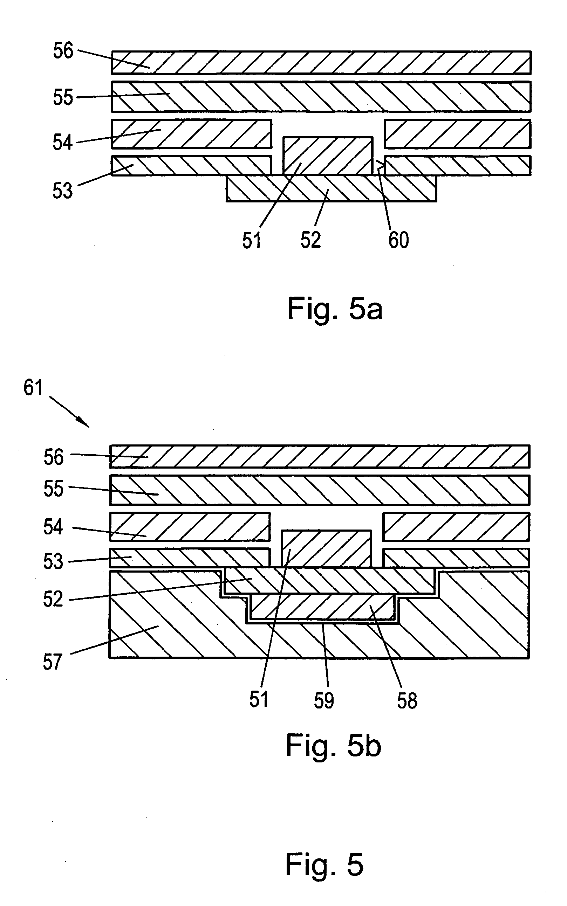

Bei der in Fig. 5a und 5b dargestellten Ausführungsform wird wiederum ein zu integrierender elektronischer Bauteil 51 auf einer abstützenden Schicht 52 abgestützt, wobei Kontakte des Bauteils 51 nicht näher dargestellt sind. Ähnlich wie bei den vorangehenden Ausführungsformen kann eine Festlegung des elektronischen Bauteils 51 auf der Schicht 52 wiederum unter Verwendung eines Klebers erfolgen.

Entsprechend den Abmessungen des zu integrierenden elektronischen Bauteils 51 ist eine leitende Schicht bzw. metallische Folie 53 wiederum mit einer entsprechenden Freistellung bzw. Ausnehmung 60 versehen, wobei ähnlich wie bei den vorangehenden Ausführungsformen darüber hinaus eine Schicht 54 aus einem isolierenden Material über der leitenden Schicht 53 angeordnet wird, wobei auch die Schicht bzw. Lage 54 eine an die Abmessungen des Bauteils 51 angepasste Freistellung aufweist. Weitere Schichten bzw. Lagen der herzustellenden Leiterplatte bzw. des Leiterplatten-Zwischenprodukts sind mit 55 und 56 angedeutet, wobei die Schicht bzw. Lage 55 ähnlich wie die Lage 54 aus einem nicht leitenden Metall, beispielsweise einem Prepreg besteht, während die Schicht bzw. Lage 56 aus einem leitenden Material bzw. einer leitenden Folie besteht.

In Fig. 5b ist dargestellt, dass für eine Integration des zu integrierenden Bauteils 51 eine weitere Schicht bzw. Lage 57, welche nach einer nicht näher dargestellten Kontaktierung der Kontakte wie bei den vorangehenden Ausführungsformen vorzusehen ist, entsprechend einer vorgesehenen Struktur bzw. Strukturierung, welche beispielsweise von der Abstützschicht 52 oder einer diese abstützende Schicht 52 ersetzenden Schicht bzw. Lage und einer schematisch angedeuteten weiteren Schicht bzw. Lage 58 gebildet ist, eine Ausnehmung 59 aufweist, um derart die im Bereich des zu integrierenden Bauteils 51 vorgesehene Struktur vollständig in der herzustellenden Leiterplatte 61 bzw. dem herzustellenden Leiterplatten-Zwischenprodukt integrieren zu können.

Anstelle eines in den Figuren dargestellten Klebers bzw. der Klebeschichten kann für eine Festlegung der zu integrierenden elektronischen Bauteile 1, 21, 31, 41, 51 auch vorgesehen sein, dass beispielsweise ein wasserlöslicher Film bzw. eine wasserlösliche Folie, welche(r) an der zu der abstützenden Schicht gerichteten Oberfläche des zu integrierenden Bauteils vorgesehen ist, für eine temporäre Festlegung des Bauteils herangezogen wird.

## Patentansprüche

1. Verfahren zur Integration wenigstens eines elektronischen Bauteils in eine Leiterplatte oder ein Leiterplatten-Zwischenprodukt, umfassend die folgenden Schritte:
- Bereitstellen einer Schicht (2, 22, 32, 42, 52) zur wenigstens temporären Abstützung des elektronischen Bauteils (1, 21, 31, 41, 51),
- Festlegen des elektronischen Bauteils (1,21, 31, 41, 51) auf der Schicht (2, 22, 32, 42, 52), wobei Kontakte (24, 23) des elektronischen Bauteils (21, 41) oder eine auf einer Oberfläche des elektronischen Bauteils (1, 3) angeordnete leitende Schicht (4, 34) zu der abstützenden Schicht (2, 22, 32, 42, 52) orientiert wird bzw. werden,
- Anordnen einer leitenden Schicht (5, 25, 35, 45, 53) auf der abstützenden Schicht (51) auf Höhe von Kontakten (24, 43) des elektronischen Bauteils (21, 41) oder einer leitenden Schicht einer Oberfläche des elektronischen Bauteils (1, 31) mit wenigstens einer Freistellung (6, 26, 38, 46, 60) entsprechend den Abmessungen des festzulegenden elektronischen Bauteils (1, 21,31, 41, 51), wobei die an den Bauteil (1, 21, 31, 41, 51) angrenzende leitende Schicht (5, 25, 35, 45, 53) von einer metallischen Folie, insbesondere Cu-Folie gebildet wird,
- wenigstens teilweises Ummanteln bzw. Abdecken des auf der abstützenden Schicht festgelegten Bauteils (1, 21, 31, 41, 51) und wenigstens von Teilbereichen der an den Bauteil (1, 21, 31, 41, 51) angrenzenden, auf der abstützenden Schicht (2, 22, 32, 42, 52) angeordneten, leitenden Schicht (5, 2 5, 35, 45, 53) mit einem isolierenden Material (7, 9, 27, 36, 48, 54, 55) beispielsweise einer Prepreg-Folie und/oder einem Harz,
- Freilegen der Kontakte (24, 43) oder der leitenden Schicht (4, 34) des elektronischen Bauteils sowie wenigstens von Teilbereichen der an den Bauteil angrenzenden, auf der abstützenden Schicht (2, 22, 32, 42, 52) angeordneten, leitenden Schicht (5, 25, 35, 45) nach einem bzw. durch ein Entfernen der abstützenden Schicht (2, 22, 32, 42), und
- wenigstens teilweises Kontaktieren der Kontakte (24, 43) oder der leitenden Schicht (4, 34) des elektronischen Bauteils (1, 21, 31, 41, 51) mit der an den Bauteil angrenzenden leitenden Schicht (5, 25, 35, 45, 53).

2. Verfahren nach Anspruch 1, **dadurch gekennzeichnet, dass** der elektronische Bauteil (1, 21, 31, 41, 51) auf der abstützenden Schicht (2, 22, 32, 42, 52) unter Vermittlung eines Klebers (3, 23, 33, 44), einer klebenden Folie, einer adhäsiven Beschichtung des Bauteils oder dgl. festgelegt wird, wobei die Klebeschicht (3, 23, 33, 44) gemeinsam mit der abstützenden Schicht (2, 22, 32, 42, 52) entfernt wird.

3. Verfahren nach Anspruch 2, **dadurch gekennzeichnet, dass** die Klebeschicht (3, 23, 33, 44) oder -folie oder Beschichtung (K) mit einer Dicke von maximal 15 µm, insbesondere etwa 0,1 bis 10 µm ausgebildet wird.

4. Verfahren nach Anspruch 1, 2 oder 3, **dadurch gekennzeichnet, dass** eine Klebeschicht durch Tintenstrahl-, Flex-, Tiefen- oder Offsetdruck aufgebracht wird.

5. Verfahren nach einem der Ansprüche 1 bis 4, **dadurch gekennzeichnet, dass** die metallische Folie (25, 45) insbesondere Cu-Folie, insbesondere für eine leitfähige Struktur mit einer Dicke von maximal 15 µm, insbesondere etwa 0,1 bis 10 µm ausgebildet wird.

6. Verfahren nach einem der Ansprüche 1 bis 4, **dadurch gekennzeichnet, dass** die metallische Folie (35), insbesondere Cu-Folie, insbesondere für eine Wärmeableitung mit einer Dicke von maximal 500 µm, insbesondere etwa 35 bis 400 µm ausgebildet wird.

7. Verfahren nach einem der Ansprüche 1 bis 6, **dadurch gekennzeichnet, dass** die an den Bauteil (21, 41) angrenzende leitende Schicht (25, 45) von einer strukturierten Schicht gebildet wird, wobei die leitende Schicht (25, 45) insbesondere nach einem Laminieren strukturiert wird.

8. Verfahren nach Anspruch 7, **dadurch gekennzeichnet, dass** bei zu der abstützenden Schicht (22, 42) gerichteten Kontakten (24, 43) des elektronischen Bauteils (21, 41) nach einer Entfernung der abstützenden Schicht (22, 42) die Kontakte (24, 43) mit der strukturierten leitenden Schicht kontaktiert bzw. verbunden werden.

9. Verfahren nach einem der Ansprüche 1 bis 6, **dadurch gekennzeichnet, dass** nach der Freilegung der leitenden Schicht (4, 34) des elektronischen Bauteils (1, 31) eine im wesentlichen vollflächige Kontaktierung mit der daran angrenzenden leitenden Schicht (5, 35) vorgenommen wird.

10. Verfahren nach Anspruch 9, **dadurch gekennzeichnet, dass** die vollflächige Kontaktierung von einer Schicht (12) aus einem leitenden Material, insbesondere wärmeleitenden Material gebildet wird.

11. Verfahren nach einem der Ansprüche 1 bis 10, **dadurch gekennzeichnet, dass** nach der Freilegung der leitenden Schicht (5, 35) oder der Kontakte (24, 43) des elektronischen Bauteils (1, 21, 31, 41) und der Kontaktierung mit der daran angrenzenden leitenden Schicht (5, 25, 35, 45) weitere Schichten (12, 13, 29, 30, 57) und/oder Strukturierungen der Leiterplatte ausgebildet bzw. vorgesehen werden.

12. Verfahren nach Anspruch 11, **dadurch gekennzeichnet, dass** die wenigstens eine weitere Schicht (57) der Leiterplatte mit einer Ausnehmung bzw. Vertiefung (59) im Bereich des integrierten elektronischen Bauteils (51) versehen wird.

## Claims

1. A method for integrating at least one electronic component into a printed circuit board or a printed circuit board intermediate product, comprising the following steps:
- providing a layer (2, 22, 32, 42, 52) to at least temporarily support the electronic component (1, 21, 31, 41, 51),
- fixing the electronic component (1, 21, 31, 41, 51) on the layer (2, 22, 32, 42, 52), wherein contacts (24, 23) of the electronic component (21, 41) are, or a conducting layer (4, 34) arranged on a surface of the electronic component (1, 3) is, oriented toward the supporting layer (2, 22, 32, 42, 52),
- arranging a conducting layer (5, 25, 35, 45, 53), which has at least one clearance (6, 26, 38, 46, 60) in accordance with the dimensions of the electronic component (1, 21, 31, 41, 51) to be fixed, on the supporting layer (51) at the height of contacts (24, 43) of the electronic component (21, 41) or of a conducting layer of a surface of the electronic component (1, 31), wherein the conducting layer (5, 25, 35, 45, 53) adjoining the component (1, 21, 31, 41, 51) is formed by a metallic foil, preferably Cu foil,
- at least partially encasing or covering the component (1, 21, 31, 41, 51) fixed on the supporting layer and at least regions of the conducting layer (5, 25, 35, 45, 53), which adjoins the component (1, 21, 31, 41, 51) and is arranged on the supporting layer (2, 22, 32, 42, 52), with an insulating material (7, 9, 27, 36, 48, 54, 55), for example a prepreg film and/or a resin,
- exposing the contacts (24, 43) or the conducting layer (4, 34) of the electronic component and at least regions of the conducting layer (5, 25, 35, 45), which adjoins the component and is arranged on the supporting layer (2, 22, 32, 42, 52), after or by removal of the supporting layer (2, 22, 32, 42), and
- making at least partial contact between the contacts (24, 43) or the conducting layer (4, 34) of the electronic component (1, 21, 31, 41, 51) and the conducting layer (5, 25, 35, 45, 53) adjoining the component.

2. The method according to Claim 1, **characterised in that** the electronic component (1, 21, 31, 41, 51) is fixed on the supporting layer (2, 22, 32, 42, 52) by way of an interposed adhesive layer (3, 23, 33, 44), an adhesive film, an adhesive coating of the component or the like, wherein the adhesive layer (3, 23, 33, 44) is removed together with the supporting layer (2, 22, 32, 42, 52).

3. The method according to Claim 2, **characterised in that** the adhesive layer (3, 23, 33, 44) or adhesive film or coating (K) is formed with a thickness of no more than 15 µm, preferably approximately 0.1 to 10 µm.

4. The method according to Claim 1, 2 or 3, **characterised in that** the adhesive layer is applied by way of ink jet, flexographic, intaglio or offset printing.

5. The method according to one of Claims 1 to 4, **characterised in that**, particularly for a conductive structure, the metallic foil (25, 45), particularly Cu foil, is formed having a thickness of no more than 15 µm, and preferably approximately 0.1 to 10 µm.

6. The method according to one of Claims 1 to 4, **characterised in that**, particularly for heat dissipation, the metallic foil (35), preferably Cu foil, is formed with a thickness of no more than 500 µm, particularly approximately 35 to 400 µm.

7. The method according to one of Claims 1 to 6, **characterised in that** the conducting layer (25, 45) adjoining the component (21, 41) is formed by a structured layer, wherein the conducting layer (25, 45) is particularly structured after lamination.

8. The method according to Claim 7, **characterised in that**, in the case of contacts (24, 43) of the electronic component (21, 41) that are directed toward the supporting layer (22, 42), the contacts (24, 43) are contacted with or connected to the structured conducting layer after removing the supporting layer (22, 42).

9. The method according to one of Claims 1 to 6, **characterised in that**, after exposing the conducting layer (4, 34) of the electronic component (1, 31), substantially full-area contact is made with the adjoining conducting layer (5, 35).

10. The method according to claim 9, **characterised in that** the full-area contact is formed by a layer (12) made of a conducting material, in particular heat-conducting material.

11. The method according to one of Claims 1 to 10, **characterised in that**, after exposing the conducting layer (5, 35) or the contacts (24, 43) of the electronic component (1, 21, 31, 41) and making contact with the adjoining conducting layer (5, 25, 35, 45), further layers (12, 13, 29, 30, 57) and/or structuring of the printed circuit board is/are formed or provided.

12. The method according to Claim 11, **characterised in that** the at least one further layer (57) of the printed circuit board is provided with a recess or depression (59) in the region of the integrated electronic component (51).

## Revendications

1. Procédé d'intégration d'au moins un composant électronique dans une carte de circuits imprimés ou dans un produit intermédiaire de cartes de circuits imprimés, comprenant les étapes suivantes consistant à :
- préparer une couche (2, 22, 32, 42, 52) servant à soutenir au moins temporairement le composant électronique (1, 21, 31, 41, 51),
- fixer le composant électronique (1, 21, 31, 41 51) sur la couche (2, 22, 32, 42, 52), sachant que des contacts (24, 43) du composant électronique (21, 41) ou une couche conductrice disposée sur une surface du composant électronique (1, 3) sont orientés en direction de la couche de soutien (2, 22, 32, 42, 52),
- disposer une couche conductrice (5, 25, 35, 45, 53) sur la couche de soutien (51) à hauteur de contacts (24, 43) du composant électronique (21, 41) ou d'une couche conductrice d'une surface du composant électronique (1, 31) avec au moins un dégagement (6, 26, 38, 46, 60) de manière à correspondre aux dimensions du composant électronique (1, 21, 31, 41, 51) à fixer, sachant que la couche conductrice (5, 25, 35, 45, 53) jouxtant le composant (1, 21, 31, 41, 51) est formée par un film en métal, en particulier par un film en Cu,
- entourer ou recouvrir d'un matériau isolant (7, 9, 27, 36, 48, 54, 55), par exemple d'un film préimprégné et/ou d'une résine, au moins en partie le composant (1, 21, 31, 41, 51) fixé sur la couche de soutien et au moins des zones partielles de la couche conductrice (5, 25, 35, 45, 53) jouxtant le composant (1, 21, 31, 41, 51), disposée sur la couche de soutien (2, 22, 32, 42, 52),
- dégager les contacts (24, 43) ou la couche conductrice (4, 34) du composant électronique ainsi qu'au moins des zones partielles de la couche conductrice (5, 25, 35, 45) jouxtant le composant, disposée sur la couche de soutien (2, 22, 32, 42, 52) après avoir retiré ou en retirant la couche de soutien (2, 22, 32, 42), et
- mettre en contact au moins en partie les contacts (24, 43) ou la couche conductrice (4, 34) du composant électronique (1, 21, 31, 41, 51) avec la couche conductrice (5, 25, 35, 45, 53) jouxtant le composant.

2. Procédé selon la revendication 1, **caractérisé en ce que** le composant électronique (1, 21, 31, 41, 51) est fixé sur la couche de soutien (2, 22, 32, 42, 52) par l'entremise d'une colle (3, 23, 33, 44), d'un film adhésif, d'un revêtement adhésif du composant ou similaire, sachant que la couche de colle (3, 23, 33, 44) est retirée conjointement avec la couche de soutien (2, 22, 32, 42, 52).

3. Procédé selon la revendication 2, **caractérisé en ce que** la couche de colle (3, 23, 33, 44) ou le film adhésif ou le revêtement (K) sont réalisés avec une épaisseur de maximum 15 µm, en particulier avec une épaisseur allant environ de 0,1 à 10 µm.

4. Procédé selon la revendication 1, 2 ou 3, **caractérisé en ce qu'**une couche de colle est appliquée par un procédé d'impression à jet d'encre, par un procédé d'impression par flexographie, par un procédé d'impression par héliogravure ou par un procédé d'impression offset.

5. Procédé selon l'une quelconque des revendications 1 à 4, **caractérisé en ce que** le film en métal (25, 45), en particulier le film en Cu, est réalisé en particulier pour une structure conductrice avec une épaisseur de maximum 15 µm, en particulier une épaisseur allant environ de 0,1 à 10 µm.

6. Procédé selon l'une quelconque des revendications 1 à 4, **caractérisé en ce que** le film en métal (35), en particulier le film en Cu, est réalisé en particulier pour une dissipation de chaleur avec une épaisseur de maximum 500 µm, en particulier une épaisseur allant environ de 35 à 400 µm.

7. Procédé selon l'une quelconque des revendications 1 à 6, **caractérisé en ce que** la couche conductrice (25, 45) jouxtant le composant (21, 41) est formée par une couche structurée, sachant que la couche conductrice (25, 45) est structurée en particulier après un laminage.

8. Procédé selon la revendication 7, **caractérisé en ce que** dans le cas de contacts (24, 43), orientés en direction de la couche de soutien (22, 42), du composant électronique (21, 41), les contacts (24, 43) sont reliés ou mis en contact avec la couche conductrice structurée après un retrait de la couche de soutien (22, 42).

9. Procédé selon l'une quelconque des revendications 1 à 6, **caractérisé en ce qu'**on effectue une mise en contact essentiellement sur toute la surface avec la couche conductrice (5, 35) jouxtant le composant après avoir dégagé la couche conductrice (4, 34) du composant électronique (1, 31).

10. Procédé selon la revendication 9, **caractérisé en ce que** la mise en contact sur toute la surface est formée par une couche (12) fabriquée à partir d'un matériau conducteur, en particulier à partir d'un matériau caloporteur.

11. Procédé selon l'une quelconque des revendications 1 à 10, **caractérisé en ce que** d'autres couches (12, 13, 29, 30, 57) et/ou d'autres structurations de la carte de circuits imprimés sont réalisées ou prévues après avoir dégagé la couche conductrice (5, 35) ou les contacts (24, 43) du composant électronique (1, 21, 31, 41) et après la mise en contact avec la couche conductrice (5, 25, 35, 45) jouxtant le composant.

12. Procédé selon la revendication 11, **caractérisé en ce que** l'autre couche (57) au moins au nombre de une de la carte de circuits imprimés est pourvue d'un évidement ou d'un renfoncement (59) dans la zone du composant électronique (51) intégré.
